(19)

Europäisches Patentamt
European Patent Office
Office européen des brevets

(11) **EP 2 933 647 A1**

(12) **EUROPEAN PATENT APPLICATION**

(43) Date of publication:
**21.10.2015 Bulletin 2015/43**

(51) Int Cl.:
**G01R 31/34** (2006.01)

(21) Application number: **14460022.8**

(22) Date of filing: **14.04.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Technology AG**
**8050 Zürich (CH)**

(72) Inventors:
• **Tkaczyk, Agnieszka**
**31-416 Krakow (PL)**

• **Ottewill, James**
**Ruislip, Middlesex HA49QY (GB)**
• **Wojcik, Mariusz**
**32-500 Chrzanow (PL)**

(74) Representative: **Chochorowska-Winiarska, Krystyna**
**ABB Sp. z o. o.,**
**Ul. Zeganska 1**
**04-713 Warszawa (PL)**

(54) **A model based diagnostic of induction machine**

(57)    The present invention is concerned with a method, an apparatus and a computer program for a model based diagnostic of induction machine for detecting a mechanical fault in an induction machine. The present invention is characterized in that the method comprises the steps: estimating a speed of a rotor of the induction machine, where the speed is estimated by applying an Extended Kalman Filter and is used for calculating estimations of the parameters of the operating induction machine; estimating parameters of the operating induction machine according to the model of an induction machine, which model is a dynamic model of the induction machine and has a form of a linear regressive estimator; checking the availability of the previously estimated parameters of the operating induction machine; calculating factors of the relative_change of the estimated parameters; comparing the value of each estimated operating parameters with a threshold values given by user for each parameter and alarming the user when at least one of the threshold values is exceeded.

Fig. 1

EP 2 933 647 A1

## Description

The present invention is concerned with a method, an apparatus and a computer program for a model based diagnostic of induction machine for detecting a mechanical fault in an induction machine.

Background of the invention

Typically, mechanical faults in an induction machine are detected through the analysis of vibration signals and/or via the spectral analysis of phase currents (so-called Motor Current Signature Analysis, or MCSA) and voltages. Mechanical faults excite specific dynamic signatures in measured signals. Standard condition monitoring methods such as MCSA or vibration analysis involve identifying these particular dynamic signatures in a measured signal and associating certain characteristics of the signature, such as amplitude or repetition frequency, with the severity of the fault. Typically the dynamic signatures excited by faults are also dependent on the operating conditions of the machine. For example, a particular dynamic signature might have an amplitude which is a function of both the severity of the fault exciting it and the load acting on the induction motor. It is often suggested that signals used for condition monitoring should always be recorded under similar operating conditions which are representative of the typical operating conditions under consideration. This is often not possible, particularly in applications where the operating conditions can regularly change.

Recently, a trend of applying neural networks and fuzzy logic in the condition monitoring of Induction Motors has begun to appear both in academic literature and in commercial products. The advantage of these approaches is that they are invariant to non-stationary operating conditions. One of the latest solutions is presented in patent EP0909380B1. The known solution relates to a model based fault detection system and a method for monitoring and predicting the maintenance requirements of electric motors and, more specifically, fractional horsepower electric motors. Using the system, it is possible to obtain information for early diagnosis of impending mechanical failure of an electric motor in the operational environment under unknown loading conditions. The system comprises a computer means coupled to voltage, current and speed sensors by a multifunction data acquisition means. The sensors provide continuous real-time information of the input voltage and current and of the output voltage signal developed by the motor's tachometer. The main disadvantage of such a system is that it requires a direct measurement of the speed of motor, via a shaft-mounted speed sensor. In many industrial applications it is extremely difficult to mount a speed sensor due to spatial restrictions. The purchasing and installation costs of speed sensors can often be unjustifiable relative to the cost of the system under consideration. Furthermore, the speed sensor represents a further component that may fail in the system; if the sensor fails then the condition monitoring approach will no longer function as intended.

### Summary of the invention

The present invention provides a model based diagnostic method of induction machine according to claim 1 and an apparatus for implementing the method according to claim 4. The present invention also provides a computer program for the model based diagnostic method according to claims 6.

The presented invention is advantageous relative to the previously described existing methods as it allows induction machine failures to be diagnosed under non-stationary operating conditions caused by load and speed variations without requiring an additional speed sensor. By basing the diagnostics of the electric induction machine on the estimated parameters of the machine, it is possible to diagnose a wide range of machine faults. By incorporating an accurate estimation of the induction machine speed into the estimation methodology the approach allows the parameters of the machine to be estimated with a greater accuracy, taking into account variations in the operating conditions of the induction machine. This in turn will reduce the likelihood of false or missed alarms due to inaccuracy in the estimation methodology. By estimating the speed using an Extended Kalman Filter, there is no need for the additional speed sensor, which can be costly to install and maintain. Additionally, it is not always possible to mount such speed sensors due to spatial requirements. Thus the presented invention allows accurate diagnostics of an induction machine to be conducted even in cases that installation of a specific speed sensors

### Brief description of the drawings

Fig.1 - shows a schematic view of a system for diagnostic of an induction machine,

Fig. 2 - shows a diagram for three and two phase stationary frame for measured data,

Fig.3 - shows a diagram of a stator voltage vector $U_s$ and its components,

Fig. 4 - shows a diagram of stator voltage vector $U_s$ and synchronously rotating reference frame,

Fig.5 - shows a an equivalent circuits of the induction machine,

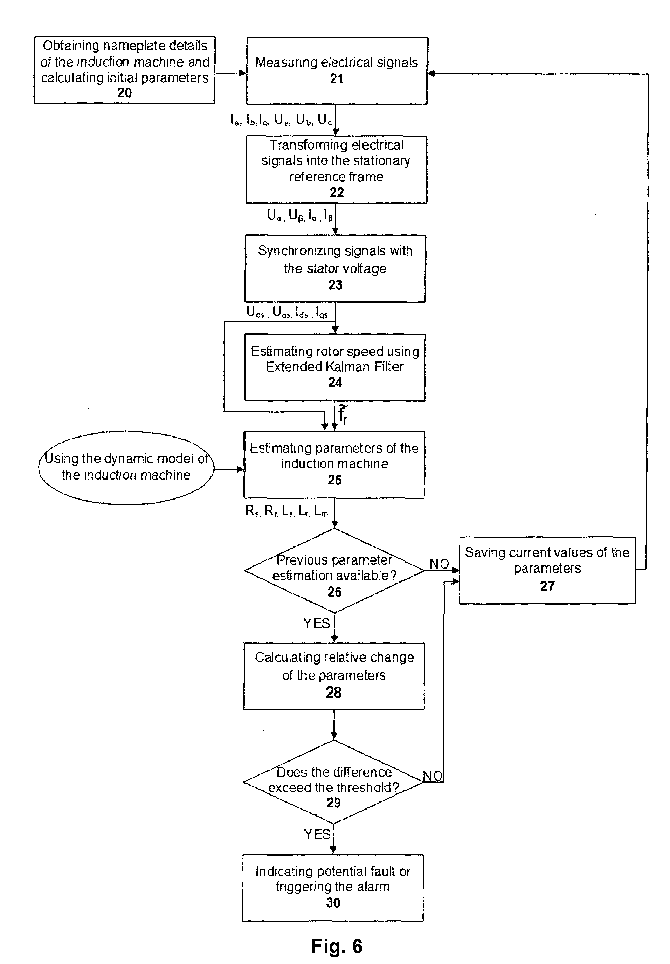

Fig.6 - shows a diagram of operations performed for model based diagnostic of induction machine according to the present invention.

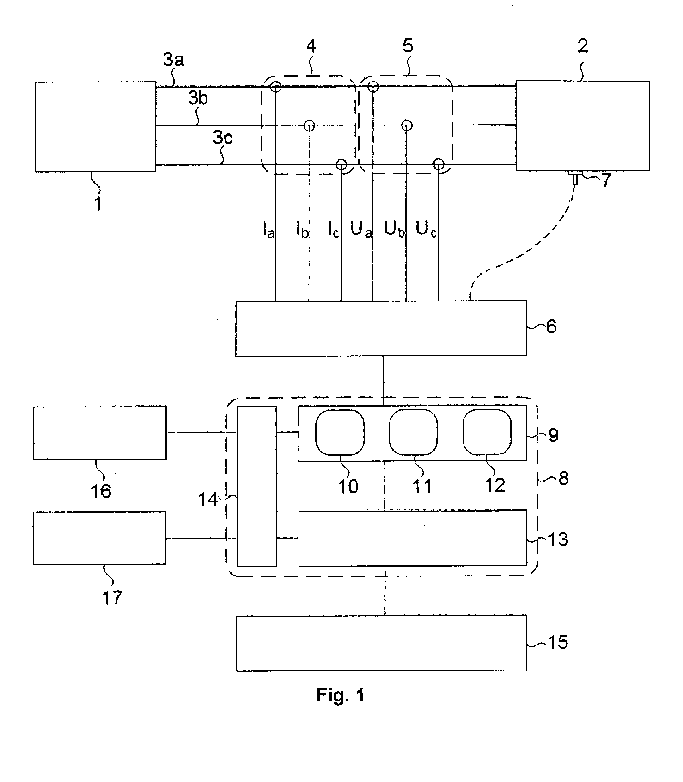

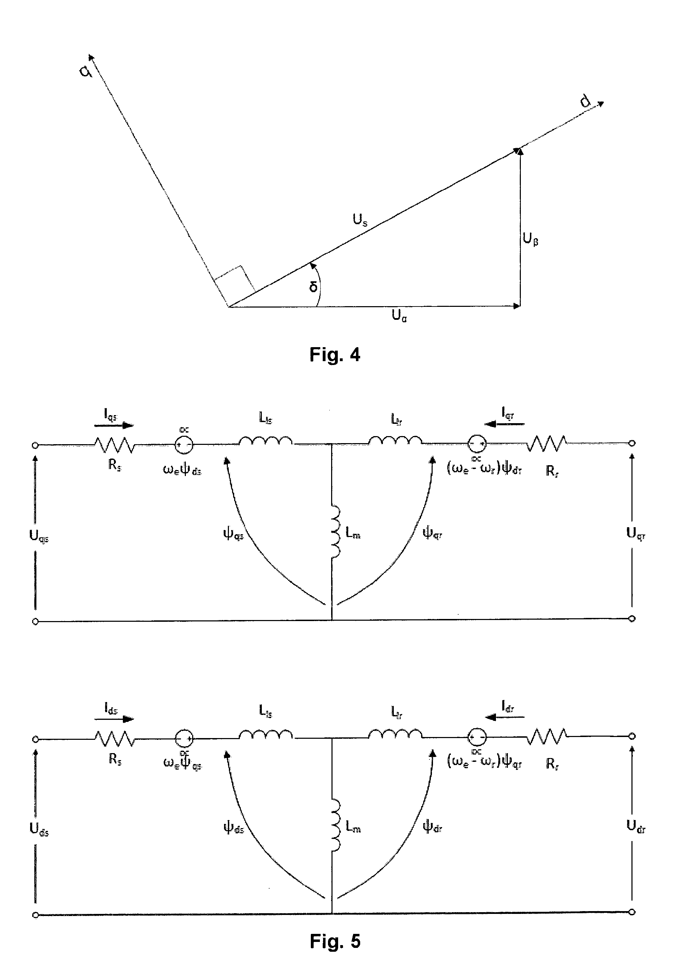

Referring to fig.1, an example of a present invention and the apparatus of this invention for the model based diagnostic of induction machine system is presented. A power supply element 1 driving an induction machine 2, having a stator and a rotor is connected to the induction machine via transmission three phase line 3a, 3b and 3c. For measurement of the current Ia, Ib, Ic in each phase a, b, c, a current sensor 4 is mounted on the transmission line 3. For measurement of the voltage Ua, Ub, Uc in each phase a, b, c a voltage sensor 5 is mounted on the transmission line 3. The sensors 4 and 5 are connected with a measurement device in the form of Digital Acquisition Unit (DAQ) 6 for measuring and processing the measured data. This unit performs standard signal processing operations, such as analog to digital signals conversion or signal amplification. Optionally a vibration sensor 7 can be used for measuring mechanical vibrations generated by the rotation of the rotor of the induction machine 2, as is indicated in the drawing by a dotted line. The vibration sensor could be an accelerometer connected to the electric motor casing and to the unit 6. The unit 6 is connected with a computer device 8 having a data processing unit 9 with a data storage module 10, a rotor speed determination module 11 with an Extended Kalman Filter (EKF) algorithm and a module 12 for implementation an algorithm for dynamic model based method. The computer device comprises also a control module 13 and a communication module 14 for introducing by user to the processing unit 9 and to the control unit 13 some kinds of data, for example a nameplates data 16 and threshold value data 17. The computer device is equipped with many standard units such as for example memories RAM, ROM, which are not presented on the drawing. The control unit 13 is connected with an output unit 15. The output unit could be a monitor, printer, or any alarming devices suitable for presentation the results of the invention or starting the alarm.
The inventive method is implemented according to the following steps 20-30 presented in fig.5.

Step 20

In step 20 the process of preparing the initial data comprises of obtaining data details from a nameplate of the induction machine 2, for example nominal supply frequency $f_s$ , a number of pole pairs p and other data concerning the induction machine 2. The process is realized by introducing such data from the user via the communication module 14 into a computer device 8 and calculating the initial parameters in a processing unit 9. The initial parameters concerned are stator resistance R'$_s$, rotor resistance R'$_r$, stator inductance L'$_s$, rotor inductance L'$_r$ and magnetizing inductance L'$_m$ and are obtained from the nameplate data by the appropriate calculation in a known way. They are rough estimates of the induction machine parameters.

Step 21

In step 21 the analog current and voltage signals $I_a$, $I_b$, $I_b$, $U_a$, $U_b$, $U_c$ of operating induction machine are measured by sensors 4 and 5 for each phase a,b,c. All signals are sent to DAQ unit 6 and processed into digital values and stored in the memory of the DAQ. The sampling frequency of the current and voltage measurements in the preferred embodiment should be equal at least 100 times the corresponding supply frequency. The preferred length of the measurement period is at least 10 seconds.

Step 22

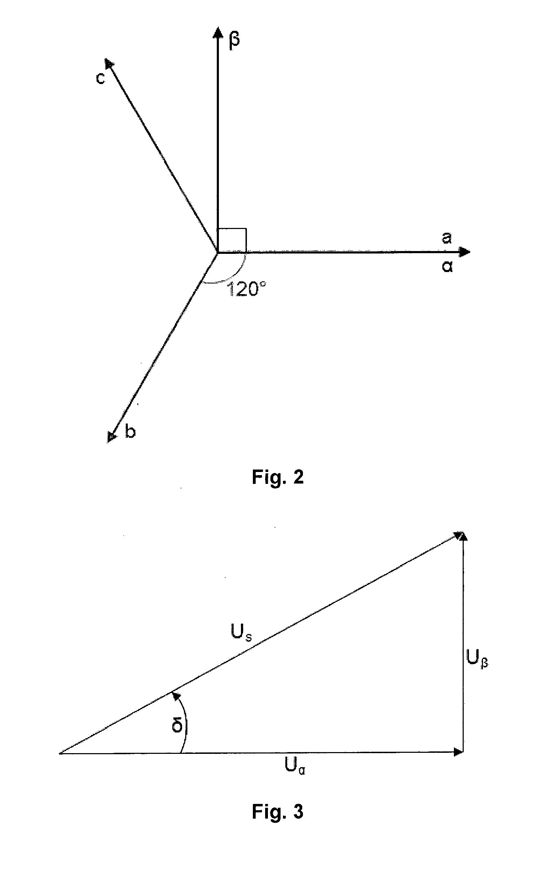

In the step 22 all electrical signals $I_a$, $I_b$, $I_c$, $U_a$, $U_b$, $U_c$ in time domain are transformed into the two phase stationary reference frame in order to obtain $U_\alpha$, $U_\beta$, $I_\alpha$, $I_\beta$ components. In Fig.2 a schematic view of the axis a, b, c and $\alpha\beta 0$ are presented.
To transform time domain signals $I_a$, $I_b$, $I_c$, $U_a$, $U_b$, $U_c$ from a natural three phase coordinate system *abc* into the stationary two phase reference frame $\alpha\beta 0$ the following formulae are used:

$$\begin{bmatrix} U_\alpha \\ U_\beta \end{bmatrix} = \begin{bmatrix} 2/3 & -1/3 & -1/3 \\ 0 & \sqrt{3}/3 & \sqrt{3}/3 \end{bmatrix} \begin{bmatrix} U_a \\ U_b \\ U_c \end{bmatrix}$$

$$\begin{bmatrix} I_\alpha \\ I_\beta \end{bmatrix} = \begin{bmatrix} 2/3 & -1/3 & -1/3 \\ 0 & \sqrt{3}/3 & \sqrt{3}/3 \end{bmatrix} \begin{bmatrix} I_a \\ I_b \\ I_c \end{bmatrix}$$

$$(1)$$

where:

$U_\alpha$ - vector of voltage $\alpha$ component in stationary reference frame,
$U_\beta$ - vector of voltage $\beta$ component in stationary reference frame,
$I_\alpha$ - vector of current $\alpha$ component in stationary reference frame,
$I_\beta$ - vector of current $\beta$ component in stationary reference frame.

Step 23

In the step 23 the vectors of voltage components $U_\alpha$, $U_\beta$ in stationary reference frame $\alpha\beta 0$ are synchronized with the stator voltage vector $U_s$ and vectors of current components $I_\alpha$, $I_\beta$ in stationary reference frame $\alpha\beta 0$ are synchronized with the stator voltage vector $U_s$.

The stator voltage vector $U_s$ is obtained by combining $U_\alpha$ and $U_\beta$ vectors according to the formula:

$$U_s = U_\alpha + jU_\beta \qquad (2)$$

where $j$ denotes imaginary unit.

To synchronize the vectors of current components $I_\alpha$, $I_\beta$ which are shifted by the angle $\delta$, where the angle $\delta$ is indicated in Fig. 3, the following rotation matrix is applied:

$$\begin{bmatrix} \cos\delta & \sin\delta \\ -\sin\delta & \cos\delta \end{bmatrix} \qquad (3)$$

where $\cos\delta$ and $\sin\delta$ are obtained using the trigonometric formulae:

$$\cos\delta = \frac{U_\alpha}{|U_s|}$$

$$\sin\delta = \frac{U_\beta}{|U_s|}$$

$$(4)$$

and $|U_s| = \sqrt{U_\alpha{}^2 + U_\beta{}^2}$ is the length of the vector $U_s$.

In order to determine the vectors of currents and voltage components synchronized with the stator voltage $I_{ds}$, $I_{qs}$, $U_{ds}$, $U_{qs}$, following formula is applied:

$$\begin{bmatrix} I_{ds} \\ I_{qs} \end{bmatrix} = \frac{1}{|U_s|} \begin{bmatrix} U_\alpha & U_\beta \\ -U_\beta & U_\alpha \end{bmatrix} \begin{bmatrix} I_\alpha \\ I_\beta \end{bmatrix}$$
$$\begin{bmatrix} U_{ds} \\ U_{qs} \end{bmatrix} = \frac{1}{|U_s|} \begin{bmatrix} U_\alpha & U_\beta \\ 0 & 0 \end{bmatrix} \begin{bmatrix} U_\alpha \\ U_\beta \end{bmatrix}$$

(5)

The above transformation is equivalent to the transformation into the two-phase synchronously rotating reference frame *dq*, where the d axis is synchronized with the stator voltage vector $U_s$, as it is shown in Fig. 4.

Step 24

In step 24 having a data transformed in the steps 22 and 23, concerning the vectors of currents and voltage components $I_{ds}$, $I_{qs}$, $U_{ds}$, $U_{qs}$ synchronized with the stator voltage $U_s$ and the data received from nameplate in the step 20, a rotor speed value $\tilde{f}_r$ of the induction machine is estimated using the known Extended Kalman Filter (EKF) algorithm according to known formulae, which are applied in the rotor speed determination module 11. The EKF is an extended variant version of Kalman filter which can deal with non-linear systems and takes into account the noise of the measured signals. A nonlinear discrete state space model required by the algorithm can be found in the literature (for example in the book of P. Vas, "Sensorless Vector and Direct Torque Control", Oxford Science Publications, 1998) and is not a subject of the present invention.

Step 25

In the step 25 the value of the speed $\tilde{f}_r$ obtained in step 24 along with the vectors of current and voltage components $I_{ds}$, $I_{qs}$, $U_{ds}$, $U_{qs}$ synchronized with the stator voltage vector $U_s$ are used to estimate parameters characterizing the induction machine $R_s$, $R_r$, $L_s$, $L_r$, $L_m$, where:

$R_s$ - stator resistance [$\Omega$],
$R_r$ - rotor resistance [$\Omega$],
$L_s$ - stator inductance [H],
$L_r$ - rotor inductance [H],
$L_m$ - magnetizing inductance [H].

In order to establish parameters characterizing the induction machine, a known Recursive Least Squares algorithm based on a linear regressive estimator *y* is employed, where in general the linear regressive estimator *y* is described as:

$$y = \phi^T \theta,$$

(6)

where:

*y* - is an output vector, representing the value of the regressive estimator,
$\phi$ - is an input vector, representing the value of the regressive vector,
$\theta$ - vector of the estimated parameters characterizing the induction machine,
$\{\ \}^T$ - transpose function.

In order to establish a linear regressive estimator for the exemplary embodiment of the invention, first a dynamic model of the induction machine in the two-phase synchronously rotating reference frame *dq* is provided. The dynamic model is implemented in the module 12 of the processing unit 9 and has a form of a set linear regressive equations. For the induction machine 2 an equivalent circuit is presented in Fig.5. The dynamic model of the induction machine in the two phase synchronously rotating reference frame *dq* is given as the following formulae:

$$\begin{cases} U_{qs} = R_s I_{qs} + \omega_e L_s I_{ds} + \omega_e L_m I_{dr} \\ U_{ds} = -\omega_e L_s I_{qs} + R_s I_{ds} - \omega_e L_m I_{qr} \\ 0 = (\omega_e - \omega_r) L_m I_{ds} + R_r I_{qr} + (\omega_e - \omega_r) L_r I_{dr} \\ 0 = (\omega_e - \omega_r) L_m I_{qs} - (\omega_e - \omega_r) L_r I_{qr} + R_r I_{dr}, \end{cases} \quad (7)$$

where:

$U_{qs}$ - is a vector of stator voltages in q reference frame [V],
$U_{ds}$ - is a vector of stator voltages in d reference frame [V],
$I_{qs}$ - is a vector stator currents in q reference frame [A],
$I_{ds}$ - is a vector of stator currents in d reference frame [A],
$I_{qr}$ - is a vector of rotor currents in q reference frame [A],
$I_{dr}$ - is a vector of rotor currents in d reference frame [A],
$R_s$ - is a stator resistance [$\Omega$],
$R_r$ - is a rotor resistance [$\Omega$],
$L_s$ - is a stator inductance [H],
$L_r$ - is a rotor inductance [H],
$L_m$ - is a magnetizing inductance [H],
$\omega_e = 2\pi f_s$ - is a stator supply frequency [rad/s], where $f_s$ is nominal supply frequency,
$\omega_r = 2\pi p \tilde{f}_r$ - is a rotor electrical speed [rad/s], where $p$ is the number of pole pairs of the induction machine and $\tilde{f}_r$ is the rotor speed value of the induction machine estimated using the known Extended Kalman Filter (EKF).

From the equivalent circuits of the dynamic model of the induction machine which satisfy the above set of equations (7) the following set of equations represented flux linkage $\psi_{qs}$, $\psi_{qr}$, $\psi_{ds}$, $\psi_{dr}$ in terms of currents is applied:

$$\begin{aligned} \psi_{qs} &= L_{ls} I_{qs} + L_m \left( I_{qs} + I_{qr} \right) \\ \psi_{qr} &= L_{lr} I_{qr} + L_m \left( I_{qs} + I_{qr} \right) \\ \psi_{ds} &= L_{ls} I_{ds} + L_m \left( I_{ds} + I_{dr} \right) \\ \psi_{dr} &= L_{lr} I_{dr} + L_m \left( I_{ds} + I_{dr} \right) \end{aligned} \quad (8)$$

where:

$\psi_{qs}$ - q-axis stator flux linkage [Wb],
$\psi_{qr}$ - q-axis rotor flux linkage [Wb],
$\psi_{ds}$ - d-axis stator flux linkage [Wb],
$\psi_{dr}$ - d-axis rotor flux linkage [Wb],
$L_{ls} = L_s - L_m$ - stator leakage inductance [H],
$L_{lr} = L_r - L_m$ - rotor leakage inductance [H].

Next the dynamic model defined in the equation (7) is applied in establishing the linear regressive estimator for the exemplary embodiment of the invention.

The linear regressive estimator $U_{qs}$ is calculated according to the following formula:

$$U_{qs}$$

$$= \begin{bmatrix} I_{qs} & \omega_e I_{ds} & \omega_e(\omega_e - \omega_r)I_{qs} & \omega_e(\omega_e - \omega_r)^2 I_{ds} \end{bmatrix} \begin{bmatrix} b_1 \\ b_2 \\ b_3 \\ -b_4 \end{bmatrix} \qquad (9)$$

Where $b_1$, $b_2$, $b_3$, $b_4$ are estimated coefficients which are the result of solving the equation (9) and are equal to:

$$b_1 = R_s,$$

$$b_2 = L_s = L_r,$$

$$b_3 = \frac{L_m^2 R_r}{(\omega_e - \omega_r)^2 L_r^2 + R_r^2},$$

$$b_4 = \frac{L_m^2 L_r}{(\omega_e - \omega_r)^2 L_r^2 + R_r^2}.$$

On the basis of the values of the estimated parameters $b_1$, $b_2$, $b_3$, $b_4$ the following electrical parameters of the induction machine are calculated:

$$\begin{aligned} R_s &= b_1, \\ L_s &= L_r = b_2, \\ R_r &= \frac{b_2 b_3}{b_4}, \\ L_m &= \sqrt{b_4(\omega_e - \omega_r)^2 b_2 + \frac{b_2 b_3^2}{b_4}}. \end{aligned} \qquad (10)$$

Step 26

In the first iteration, when the parameters of the induction machine $R_s$, $R_r$, $L_s$, $L_r$, $L_m$, are estimated in the step 25, the value of these parameters are compared with initial values of the parameters R'$_s$, R'$_r$, L'$_s$, L'$_r$, L'$_m$ which have been calculated and saved by the user in the step 20. In the next iterations, values of the parameters estimated in step 25 are compared with the values calculated in the previous iteration, provided that such parameters are available. If the initial or previously calculated parameters are not accessible then the current values are saved in the step 27. If previously calculated parameters are available then step 28 is performed.

Step 27

In the step 27 all of the estimated parameters of the induction machine $R_s$, $R_r$, $L_s$, $L_r$, $L_m$ calculated in the current iteration are saved and sent to the step 21 as a new initial parameters R'$_s$, R'$_r$, L'$_s$, L'$_r$, L'$_m$ for the next iteration.

Step 28

In the step 28 for each of the estimated parameters of the induction machine $R_s$, $R_r$, $L_s$, $L_r$, $L_m$ a factor named as relative_change and concerning the all estimated parameters is calculated according to the following formula:

$$\text{relative\_change} = \frac{|\text{estimated\_parameter} - \text{initial\_parameter}|}{\text{initial\_parameter}} 100\% \qquad (1)$$

where:

relative_change - relative difference of the parameter in percentage,
estimated_parameter - parameter estimated in the step 25,
initiaLparameter - parameter estimated in the previous iteration carried out in step 25 or initial parameters pre-defined in the step 20.

For example, if the initial parameter of the stator resistance $R'_s$ is equal to 4Ohm and estimated parameter of the stator resistance $R_s$ is equal to 5Ohm:

$$\text{relative\_change\_R}_s = \frac{|5 - 4|}{4} 100\% = 25\%$$

In the same manner relative change of each of the parameters are calculated. Provided that the initial rotor resistance $R'_r$ is equal to 3Ohm and estimated rotor resistance $R_r$ is equal to 3,5Ohm:

$$\text{relative\_change\_R}_r = \frac{|3,3 - 3|}{3} 100\% = 10\%$$

Given that the initial stator inductance $L'_s$ is equal to 0,02H and estimated stator inductance $L_s$ is equal to 0,019H:

$$\text{relative\_change\_L}_s = \frac{|0,019 - 0,02|}{0,02} 100\% = 5\%$$

Given that the initial rotor inductance $L'_r$ is equal to 0,02H and estimated stator inductance $L_r$ is eaual to 0,021H:

$$\text{relative\_change\_L}_r = \frac{|0,021 - 0,02|}{0,02} 100\% = 5\%$$

Given that initial stator inductance $L'_m$ is equal to 0,018H and estimated stator inductance $L_m$ is equal to 0,016H:

$$\text{relative\_change\_L}_m = \frac{|0{,}018 - 0{,}016|}{0{,}016} 100\% = 12{,}5\%$$

Step 29

In the step 29 the factor relative_change is verified against the predefined threshold values introduced by the user to the control unit 13 of the computer device 8. If any of the relative_changes of the parameters calculated in the step 28 are bigger than the predefined threshold values i.e.:

$$\text{relative\_change} > \text{threshold\_value}$$

a signal indicating potential fault is triggered in the control unit 13 and sent to the alarming device 15 to start a remedy action.

For example, if the threshold value is set to 20%, the relative change of each of the estimated parameters is verified against this threshold, i.e:

$$\text{relative\_change\_R}_s = 25\% > 20\%$$

$$\text{relative\_change\_R}_r = 10\% < 20\%$$

$$\text{relative\_change\_L}_s = 5\% < 20\%$$

$$\text{relative\_change\_L}_r^{'} = 5\% < 20\%$$

$$\text{relative\_change\_L}_m = 12{,}5\% < 20\%$$

Since the relative change of the stator resistance is greater than the given threshold, a signal indicating potential fault will be triggered.

In all other cases, the estimated values of the induction machine parameters $R_s$, $R_r$, $L_s$, $L_r$, $L_m$ are saved as initial parameters $R'_s$, $R'_r$, $L'_s$, $L'_r$, $L'_m$ and the electrical signals are measured again in the next iteration.

Step 30

In step 30 a potential fault is indicated or the alarm is triggered with the use of an output unit 15. The next measurements are not collected anymore until the maintenance action would be performed. Once the induction machine is back from the service, the algorithm starts from the step number 20.

**Claims**

**1.** A model based diagnostic method of induction machine comprising the steps of:

- providing a model of an induction machine on a computer device,
- connecting the induction machine to the computer through current and voltage sensors,
- measuring the current and voltage signals of the operating induction machine,
- calculating the initial operating parameters of the induction machine on the basis of the model of an induction machine,

**characterized in that** it further comprises of the following steps:

- estimating a speed of a rotor of the induction machine, where the speed is estimated by applying an Extended Kalman Filter and is used for calculating estimations of the parameters of the operating induction machine,
- estimating parameters of the operating induction machine according to the model of an induction machine, which model is a dynamic model of the induction machine and has a form of a linear regressive estimator,
- checking the availability of the previously estimated parameters of the operating induction machine and, if unavailable, repeat measurement of current and voltage signals for receiving new estimated parameters of the operating induction machine, and, if available, go to the next step,
- calculating factors of the relative_change of the estimated parameters,
- comparing the value of each estimated operating parameters with a threshold values given by user for each parameter,
- and alarming the user when at least one of the threshold values is exceeded.

2. The method according to step 1, **characterized in that** the linear regressive estimator $U_{qs}$ is defined in the following formulae:

$$U_{qs} = \begin{bmatrix} I_{qs} & \omega_e I_{ds} & \omega_e(\omega_e - \omega_r) I_{qs} & \omega_e(\omega_e - \omega_r)^2 I_{ds} \end{bmatrix} \begin{bmatrix} b_1 \\ b_2 \\ b_3 \\ -b_4 \end{bmatrix}$$

Where:

$I_{qs}$ -is a vector of stator currents in q reference frame,
$I_{ds}$ - is a vector of stator currents in d reference frame,
$I_{qr}$ - is a vector of rotor currents in q reference frame,
$I_{dr}$ - is a vector of rotor currents in d reference frame,
$\omega_e$ - is a stator supply frequency,
$\omega_r$ - is a rotor electrical speed,
$b_1$, $b_2$, $b_3$, $b_4$ - are estimated coefficients which are the result of solving the equation for $U_{qs}$ and are equal to:

$$b_1 = R_s,$$

$$b_2 = L_s = L_r,$$

$$b_3 = \frac{L_m^2 R_r}{(\omega_e - \omega_r)^2 L_r^2 + R_r^2},$$

$$b_4 = \frac{L_m^2 L_r}{(\omega_e - \omega_r)^2 L_r^2 + R_r^2}$$

And where:

$R_s$ - is an estimated stator resistance,
$R_r$ - is an estimated rotor resistance,
$L_s$ - is an estimated stator inductance,
$L_r$ - is an estimated rotor inductance,
$L_m$ - is an estimated magnetizing inductance.

3.  The method according to step 1, is **characterised in that** the step of calculating the factor relative_change of the estimated parameter of operating machine is realized according to the following formulae:

$$\text{relative\_change} = \frac{|\text{estimated\_parameter} - \text{initial\_parameter}|}{\text{initial\_parameter}} 100\%$$

where:

relative_change - is a relative difference of the operating parameter in percentage,
estimated_parameter - is an estimated parameter of the induction machine,
initial_parameter - is an parameter estimated iteration carried out in each previous step of estimating the operating parameters of the induction machine or initial parameters pre-defined by user and calculated for the initial data.

4.  An apparatus for implementing the method according to claims 1-4 comprising:

• means for providing a model of an induction machine on a computer device,
• means for connecting the induction machine to the computer device through current and voltage sensors,
• means for measuring the current and voltage signals of the operating induction machine,
• means for calculating the initial operating parameters of the induction machine on the basis of the model of an induction machine,
• means for estimating a speed of a rotor of the induction machine, where the speed is estimated by applying an Extended Kalman Filter and is used for calculating estimating parameters of the operating induction machine,
• means for estimating parameters of the operating induction machine according to the model of an induction machine, which model is a dynamic model of the induction machine and has a form of a linear regressive estimator,
• means for checking the availability of the previously estimated parameters of the operating induction machine and if unavailable means for repeat measurement of current and voltage signals for receiving new estimated parameters of the operating induction machine,
• means for calculating a factor relative_change of the estimated parameter,
• means for comparing the value of the estimated operating parameters with a threshold value given by user,
• means and alarming the user when the threshold value is exceeded.

5.  An apparatus according to claim 4 wherein means for estimating parameters of the operating induction machine according to the model of an induction machine are implemented in a module (12) for implementation of an algorithm for dynamic model based method and means for estimating a speed of a rotor of the induction machine are implemented in a module (11) for rotor speed determination module (11), which are provided to the processing unit (9) of a computer device (8).

6.  An apparatus according to claim 5 wherein module (11) is providing with the Extended Kalman Filter algorithm.

7.  A computer program for the model based diagnostic method of induction machine, which computer program is loadable in and executable on data processing unit (9) of a computer device (8) and which computer program performs when being executed by the data processor of the computer, the method according to claims 1-3.

**Fig. 1**

**Fig. 2**

**Fig. 3**

**Fig. 4**

**Fig. 5**

**Fig. 6**

Europäisches
Patentamt

European
Patent Office

Office européen
des brevets

## EUROPEAN SEARCH REPORT

Application Number

EP 14 46 0022

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MOHAMED SAID NAIT SAID ET AL: "DETECTION OF BROKEN BARS IN INDUCATION MOTORS USING AN EXTENDED KALMAN FILTER FOR ROTOR RESISTANCE SENSORLESS ESTIMATION", IEEE TRANSACTIONS ON ENERGY CONVERSION, IEEE SERVICE CENTER, PISCATAWAY, NJ, US, vol. 15, no. 1, 1 March 2000 (2000-03-01), pages 66-70, XP001124674, ISSN: 0885-8969, DOI: 10.1109/60.849118 * the whole document * | 1-7 | INV. G01R31/34 |
| X | DANIEL F LEITE ET AL: "Real-Time Model-Based Fault Detection and Diagnosis for Alternators and Induction Motors", ELECTRIC MACHINES&DRIVES CONFERENCE, 2007. IEMDC '07. IEEE INTERNATIONAL, IEEE, PISCATAWAY, NJ, USA, 1 May 2007 (2007-05-01), pages 202-207, XP031114835, DOI: 10.1109/IEMDC.2007.382691 ISBN: 978-1-4244-0742-2 * abstract; figure 1 * | 1-7 | |
| A | K. RADHAKRISHNAN ET AL: "Joint State and Parameter Estimation of Squirrel Cage Induction Motor A System Identification Approach using EM based Extended Kalman Filter", INTERNATIONAL JOURNAL OF COMPUTER APPLICATIONS, vol. 27, no. 1, 1 August 2011 (2011-08-01), pages 24-29, XP055143341, DOI: 10.5120/3267-4426 * the whole document * | 1-7 | TECHNICAL FIELDS SEARCHED (IPC)<br><br>G01R |

-/--

The present search report has been drawn up for all claims

| Place of search | Date of completion of the search | Examiner |
|---|---|---|
| Munich | 29 September 2014 | Dogueri, Ali Kerem |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

      .......................................................................................................
& : member of the same patent family, corresponding
document

EPO FORM 1503 03.82 (P04C01)

Europäisches
Patentamt

European
Patent Office

Office européen
des brevets

**EUROPEAN SEARCH REPORT**

Application Number

EP 14 46 0022

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | IWASAKI T ET AL: "APPLICATION OF AN EXTENDED KALMAN FILTER TO PARAMETER IDENTIFICATION OF AN INDUCTION MOTOR", CONFERENCE RECORD OF THE INDUSTRY APPLICATIONS SOCIETY ANNUAL MEETING. (IAS). SAN DIEGO, OCT. 1 - 5, 1989; [CONFERENCE RECORD OF THE INDUSTRY APPLICATIONS SOCIETY ANNUAL MEETING. (IAS)], NEW YORK, IEEE, US, vol. PART 01, 1 October 1989 (1989-10-01), pages 248-253, XP000091586, * the whole document * | 1-7 | |
| A | HONGZHONG MA ET AL: "Parameter identification and its application in fault diagnosis of asynchronous motor", ELECTRICAL MACHINES AND SYSTEMS, 2007. ICEMS. INTERNATIONAL CONFERENCE ON, IEEE, PI, 8 October 2007 (2007-10-08), pages 1824-1828, XP031823713, ISBN: 978-89-86510-07-2 * the whole document * | 1-7 | TECHNICAL FIELDS SEARCHED (IPC) |

The present search report has been drawn up for all claims

| Place of search | Date of completion of the search | Examiner |
|---|---|---|
| Munich | 29 September 2014 | Dogueri, Ali Kerem |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0909380 B1

**Non-patent literature cited in the description**

- **P. VAS.** Sensorless Vector and Direct Torque Control. Oxford Science Publications, 1998